# EUROPEAN PATENT SPECIFICATION

(11) **EP 1 766 428 B1**
(45) Date of publication and mention of the grant of the patent: **17.09.2008**
(21) Application number: 05761090.9
(22) Date of filing: 06.07.2005
(51) Int. Cl.: G01R 31/3185

(54) **TESTING A PIPELINE IN AN IC**
TESTEN EINER PIPELINE IN EINEM INTEGRIERTEN SCHALTKREIS
ESSAI DE PIPELINE DANS UN CI

(30) Priority: 07.07.2004 EP 04103207
(43) Date of publication of application: 28.03.2007
(73) Proprietor: NXP B.V., 5656 AG Eindhoven (NL)
(72) Inventor: VAN KAAM, Kees, c/o Philips Int. Prop. & Standards, Surrey RH1 5HA (GB); WIELAGE, Paul, c/o Philips Int. Prop. & Standards, Surrey RH1 5HA (GB)
(74) Representative: White, Andrew Gordon
(86) International application number: PCT/IB2005/052246
(87) International publication number: WO 2006/006132

(56) References cited:
- US-A- 5 740 181
- US-A- 6 073 265
- US-A1- 2002 069 384
- US-A1- 2004 120 181

## Description

The invention relates to an architecture for testing a pipeline such as an embedded mousetrap FIFO, and in particular to an architecture that requires less hardware, and hence less silicon area, than conventional testing architectures.

A mousetrap FIFO, as described in "MOUSETRAP: Ultra-High-Speed Transition-Signaling Asynchronous Pipelines" by M. Singh and S. Nowick, is an asynchronous pipeline design that is suitable for high-speed applications.

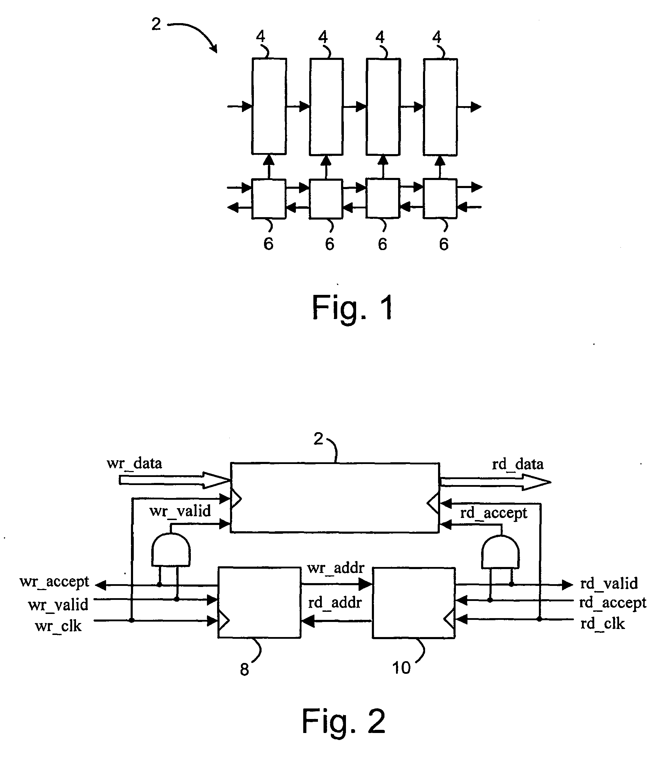

Fig. 1 shows the basic mousetrap FIFO structure. The pipeline 2 comprises a number of latches 4 connected together to form a data path, and latch controllers 6 connected to each latch 4 to control the movement of data through the pipeline 2. As there is no global clock signal in an asynchronous pipeline, each latch controller 6 communicates with the preceding and following stages using "request" and "acknowledgement" signals to determine when to open and close the latches 4.

The mousetrap FIFO is so-called as the latching action of a pipeline stage is similar to the operation of a mousetrap. Specifically, the latches are transparent (i.e. their output matches their input) before data arrives, and they are closed as soon as data passes through. In alternative asynchronous pipelines, a latch is only opened (made transparent) after new data has arrived and has stabilized at its input.

When the asynchronous mousetrap pipeline 2 is to be embedded in a synchronous system (i.e. a system that uses a global clock signal), the pipeline 2 must be 'wrapped' so that there is a synchronous write port for writing data to the pipeline 2 and a synchronous read port for reading data from the pipeline 2.

Fig. 2 shows an asynchronous pipeline 2 and an example of a 'wrapper' required to embed the asynchronous pipeline 2 into a synchronous system. A write control block 8 and read control block 10 are provided, each receiving a respective clock signal from the synchronous system (*wr_clk* and *rd_clk*). This 'wrapper' allows the asynchronous pipeline 2 to interface with the synchronous system.

To minimize the silicon area used by the mousetrap FIFO, it is a completely implemented full custom design and is therefore integrated as a hard macro.

As with any system, there must be a strategy for testing the system that does not significantly increase the hardware required to implement the system. The test strategy must be capable of testing the pipeline with a high coverage without much hardware overhead, to make sure the silicon area of the pipeline remains small. Typically the pipeline is embedded into a logic design, and several pipelines are used in a particular design.

These embedded pipelines cannot be tested with standard test approaches (e.g. scantest), since the pipeline does not use standard memory cells such as flip-flops, and the pipeline is a hard macro.

US patent US 5,740,181 discloses a pipeline having scan registers inserted between pipeline stages for capturing the content of the pipeline stages in a test mode.

US patent application US2002/069384 discloses an apparatus for testing pipelined dynamic logic by means of scanning logic connected to the pipeline.

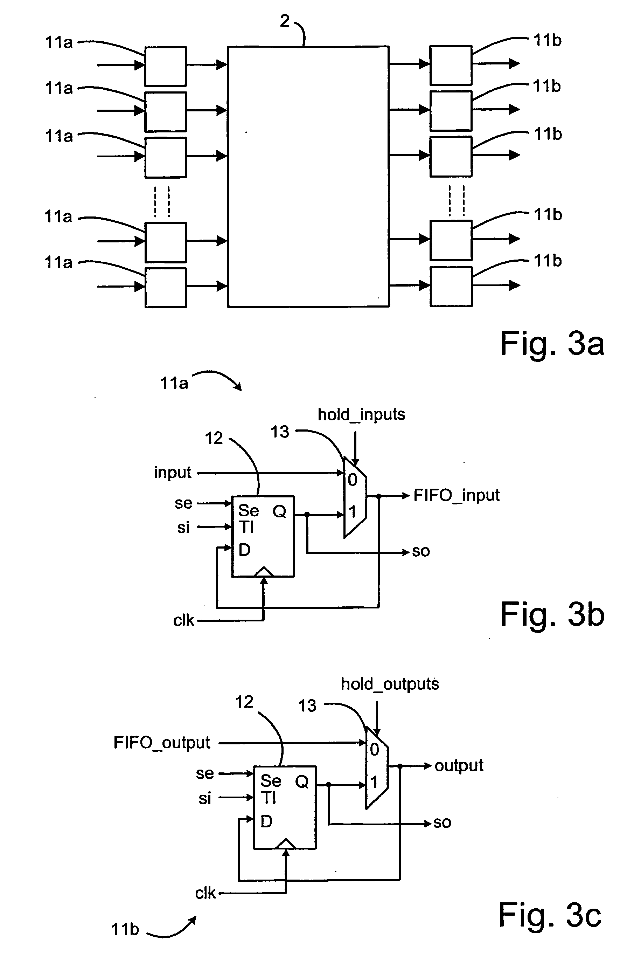

One way of allowing the pipeline to be tested is shown in Fig. 3a. Here, the pipeline 2 is surrounded by test points 11a at each of its inputs and test points 11b at each of its outputs, to make test access and test control to the pipeline 2 possible.

The structure of the test points 11a and 11b is shown in Figs. 3b and 3c, respectively. Each test point comprises a scan flip-flop 12 and multiplexer 13.

A scan chain can be constructed by connecting the so port of one test point 11a or 11b to the si port of the next test point 11a or 11b. This allows functional test stimuli to be applied to the pipeline 2 and the pipeline responses to be stored.

The multiplexer 13 in a test point 11a at an input to the pipeline 2 is used to apply a stimulus to the pipeline 2 during testing, or to capture the value of the signal input when the logic of the rest of the system (i.e. excluding the FIFO) is being tested.

The multiplexer 13 in a test point 11b at an output of the pipeline 2 is used to capture the value of the *FIFO_output* signal during testing of the pipeline 2, or to apply a stimulus at the output port for testing the logic of the rest of the system. Test points 11a and 11b are also used to apply test stimuli to the *wr_valid* and *rd_accept* signals.

However, this test point approach requires a large silicon area and reduces the advantages of using the small pipeline.

It is therefore an object of the present invention to provide an architecture for testing pipelines in an IC that requires less silicon area than conventional testing architectures. The invention is defined by the independent claims. The dependent claims define advantageous embodiments.

According to a first aspect of the present invention, there is provided an architecture for testing a pipeline in an integrated circuit, the pipeline having an input port and an output port, and being operable to process a data word having a plurality of data bits. The architecture comprises a multiplexer provided at each input of the input port of the pipeline, each multiplexer operable to allow a data bit or test data bit to be input to the pipeline. A write test block is operable to control the writing of data bits or test data bits to the pipeline during a normal or test mode of operation, and a read test block is operable to control the reading of data bits or test data bits from the pipeline during a normal or test mode of operation. The write test block and the read test block are operable in a test mode to control the pipeline as a scan chain.

For a better understanding of the present invention, and to show more clearly how it may be carried into effect, reference will now be made, by way of example, to the following drawings, in which:
Fig. 1 is a block diagram of a basic mousetrap FIFO structure;
Fig. 2 is a block diagram of a wrapper used to embed a mousetrap FIFO into a synchronous system;
Fig. 3a is a block diagram of a conventional architecture for testing an embedded mousetrap FIFO;
Fig. 3b is a block diagram of a conventional test point for an input to a mousetrap FIFO;
Fig. 3c is a block diagram of a conventional test point for an output from a mousetrap FIFO;
Fig. 4 is a block diagram of a test architecture according to the present invention;
Fig. 5 is a block diagram of a write test block according to a first embodiment of the present invention;
Fig. 6 is a block diagram of a read test block according to the first embodiment of the present invention;
Fig. 7 is a block diagram of a write test block in accordance with a second embodiment of the present invention;
Fig. 8 is a block diagram of a read test block in accordance with the second embodiment of the present invention;
Fig. 9 is a schematic view of the memory of a mousetrap FIFO;
Fig. 10 shows a scan test with a single storage element;
Fig. 11 shows a scan test with multiple storage elements; and
Fig. 12 shows a functional test with a checkerboard pattern.

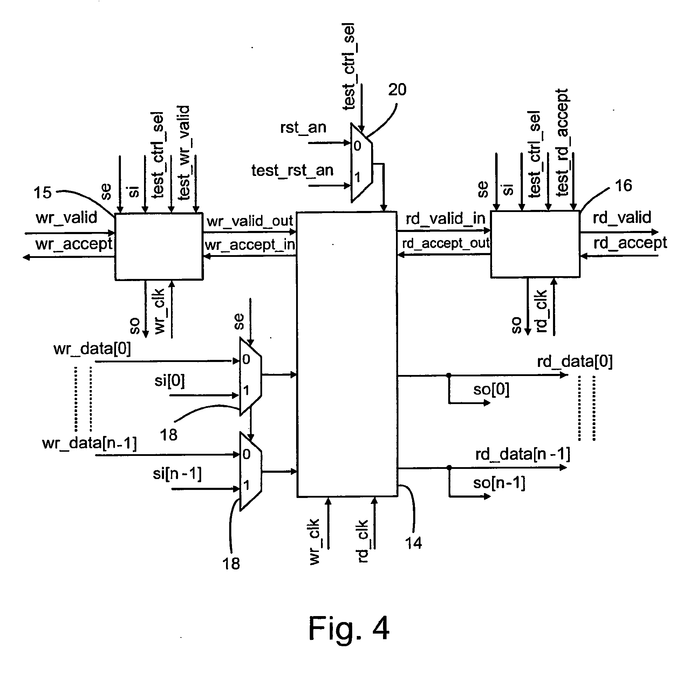

Fig. 4 shows a test architecture wrapper according to the present invention. A mousetrap FIFO 14 (which includes a wrapper for embedding the FIFO into a synchronous system) is connected to a write test block 15 and a read test block 16. During testing and normal operation of the FIFO 14, these blocks generate and control the *wr_valid_out* and *rd_accept_out* signals for the pipeline 14, respectively.

The write test block 15 and read test block 16 each receives a respective clock signal from the synchronous system (*wr_clk* and *rd_elk*), and the pipeline 14 receives both of the clock signals from the synchronous system. Of course, the synchronous system may use a single clock signal and therefore *wr_clk* will be the same as *rd_clk.*

Unlike in conventional test architectures where a test point comprising a scan flip-flop and multiplexer is required at each input and output of the pipeline, the test architecture according to the present invention only requires multiplexers 18 at the data *inputs* of the pipeline 14. These multiplexers are used to provide an extra port, the *si[..]* port, at each of the inputs to the pipeline for allowing test data to be introduced. Therefore there is one multiplexer 18 at the input of the pipeline 14 for each bit in a data word processed by the pipeline 14.

For example, if a data word processed by the pipeline 14 comprises 8 bits, there will be 8 multiplexers 18 at the inputs to the pipeline 14, one for each bit. In Fig. 4, there are *n* bits in a data word and therefore *n* multiplexers 18.

Each multiplexer 18 receives a data bit, *wr_data[..]*, for that input of the pipeline 14 when the pipeline is operating in a normal functional mode, a scan test bit, *si[..]*, for use during a scan test mode, and a scan enable signal *se.* The scan enable signal *se* controls the multiplexer 18 so that the bits at the inputs of the pipeline 14 are data bits *wr_data[..]* during a normal functional mode or scan test bits *si[..]* during a scan test mode.

The write test block 15 and the read test block 16 also receive the scan enable signal se. The scan enable signal *se* is logic high when the scan mode is enabled and logic low when the pipeline is working in its normal functional mode.

As described above, the architecture according to the present invention does not use a scan flip-flop and multiplexer at each data bit input and data bit output of the FIFO, but instead uses a single multiplexer at each data bit input. Therefore, the mousetrap FIFO 14 is controlled during a scan test mode so that it behaves as though it is a single flip-flop for every data bit. If the FIFO 14 is controlled in the proper way by the write test block 15 and read test block 16 then the FIFO 14 works like a scan chain.

The scan chain input ports are denoted *si[0..n-1]* (the same as the scan test input bits received at each of those ports) and the scan chain output ports are denoted *so[0..n-1]* (from which the scan test output bits *so[0..n-1]* are received). These ports can be combined in several different ways according to the invention.

A first type of scan chain can be formed by connecting each scan chain output port *so[0..n-1]* to a scan input port *si[0..n-1]* of the same pipeline 14. For example, the first output port *so[0]* can be connected to the second input port *si[1]*, and the second output port *so[1]* can be connected to the third input port *si[2]*. Hence, a scan chain is formed that has a length equal to the number of data bits in a data word (the *'datawidth')* multiplied by the number of data words stored in the pipeline 14.

A second type of scan chain can be formed when there are multiple mousetrap FIFOs in the system. For example, the first scan output port *so[0]* of the first FIFO can be connected to the first scan input port *si[0]* of the second FIFO, and so on. This results in the creation of a number of scan chains with a length equal to the total number of data words stored in all of the FIFOs.

It will be appreciated that alternative scan chains can be created, and that combinations of the above two techniques are also possible.

All of the scan chains, whether or not they involve multiple FIFOs, are controlled by a single scan enable signal *se.*

A reset signal, *rst_an*, is used to initialize or reset the pipeline 14. This signal must be controlled during the scan test mode and a multiplexer 20 is provided that receives the reset signal *rst_an*, a test mode reset signal *test_rst_an* and a test mode select signal *test_ctrl_sel* for selecting the output of the multiplexer 20.

If there are several mousetrap FIFOs in the design, this multiplexer 20 and the associated control signals are reused for each mousetrap FIFO, so it is not necessary to include a multiplexer 20 for each FIFO.

During a scan test mode, the FIFO must first be reset (i.e. *test_ctrl_sel* is logic one and *test_rst_an* is held logic low) and then the reset signal *test_rst_an* is kept logic high during testing.

During testing, all clock ports must be connected to a common clock signal, which is standard for scan testing.

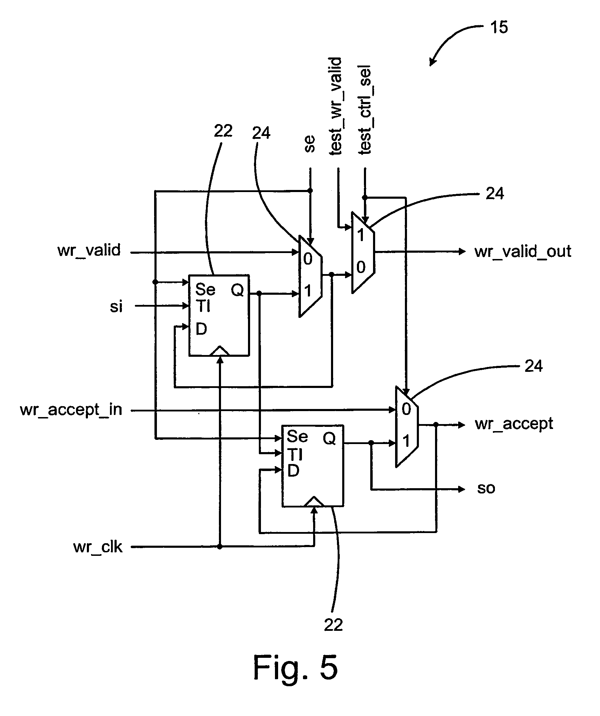

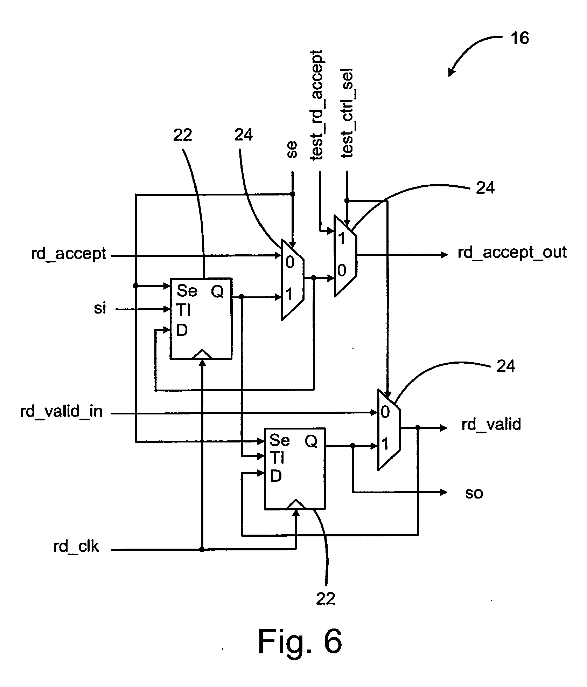

Figs. 5 and 6 are block diagrams of a write test block 15 and read test block 16 according to a first embodiment of the present invention respectively. As described above, the purpose of the write test block 15 and read test block 16 is to control the *wr_valid_out* and *rd_accept_out* signals for the pipeline 14 respectively. In addition, to increase the test coverage, the signals *rd_valid* and *wr_accept* can be controlled and the signals *rd_accept* and *wr_valid* (received from the synchronous system) can be observed. The write and read test blocks 15, 16 each comprise two scan flip-flops 22 and three multiplexers 24.

Control of the *wr_valid_out* and *rd_accept_out* signals is accomplished with the test control signals *test_ctrl_sel*, *test_wr_valid* and *test_rd_accept* (these latter two signals being received by the write test block 15 and read test block 16 respectively).

Data is written to the mousetrap FIFO 14 when *wr_valid_out* is logical one, and data is read out of the FIFO 14 when *read_accept_out* is logical one. So, when both of these signals are logical one, there is data written and read in a single clock cycle. This results in a shifting behavior, which is the same as scanning data through a scan chain.

All of the test control signals (*test_ctrl_sel*, *test_wr_valid* and *test_rd_accept*) can be shared for all the FIFOs in the system to reduce the amount of hardware required. These signals can be generated directly from chip pins, a Test Control Block (TCB), a JTAG port or a combination of a TCB with JTAG.

Both test blocks 15, 16 have a scan test data input port *si* and a scan test data output port *so* so that test data can be scanned into and out of the blocks. The length of the scan chain in each of the blocks is two. Alternatively, there can be two scan chains with length of one instead of a single scan chain with length two.

Table 1 provides an overview of the values of the test control signals for different modes of operation of the invention. The *Application* mode is the mode in which the pipeline 14 is operating normally. The *Test:scan* mode is the mode in which data is scanned in and out through the scan chains. The *Test:normal* mode is the mode in which scan functionality is disabled and test data is directly applied to the pipeline 14 and responses captured. The mode *Write word* is used to write a word with random data content into the pipeline 14 to fill the pipeline with data, and the mode *Read word* is used to read a word from the pipeline 14 that is effectively lost during a test and to empty the pipeline.

**Table 1**

| Mode | *se* | *test_ctrl_sel* | *test_wr_valid* | *test_rd_accept* |
|---|---|---|---|---|
| Application | 0 | 0 | X | X |
| Test:scan | 1 | 1 | 1 | 1 |
| Test:normal | 0 | 1 | 1 | 1 |
| Write word | 0 | 1 | 1 | 0 |
| Read word | 0 | 1 | 0 | 1 |

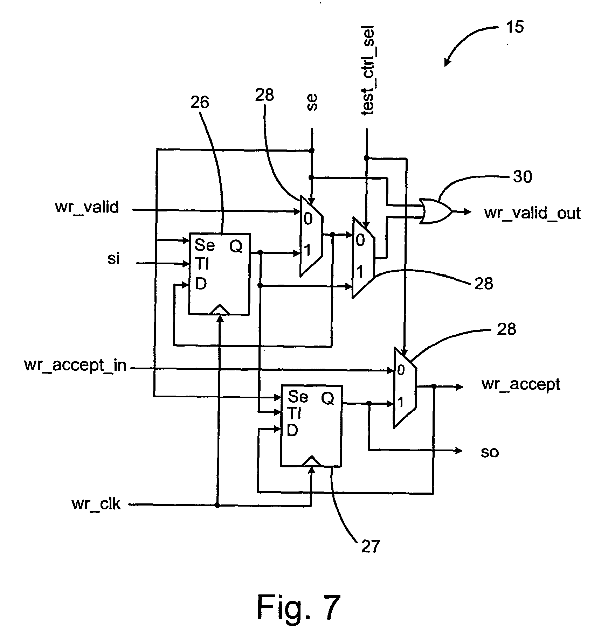

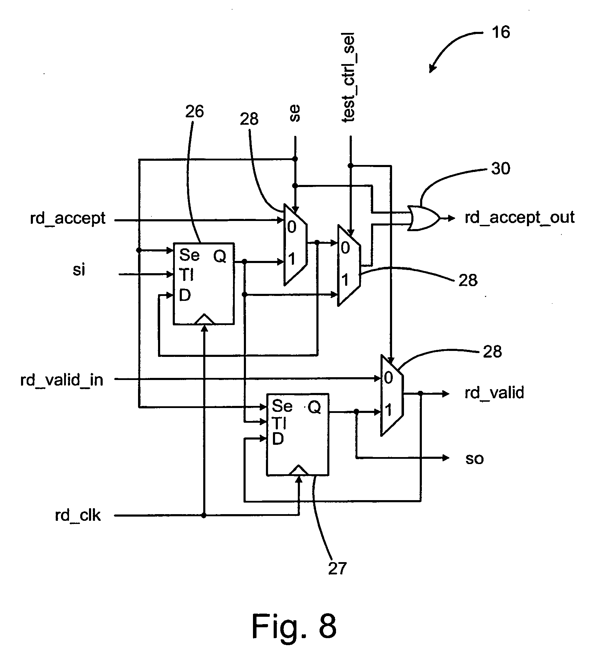

Figs. 7 and 8 are block diagrams of a write test block 15 and read test block 16 according to a second embodiment of the present invention respectively.

These write and read test blocks are similar to those of the first embodiment, however, fewer control signals are required. Specifically, the control signals *wr_valid_out* and *rd_accep_out* are generated during the test modes using the output value of the flip-flop 26 in the write test block 15 and read test block 16 respectively, and the scan enable signal *se.* The result is that the control signals *wr_valid_out* and *rd_accept_out* are always logic one when the scan enable signal *se* is logic one, which means that the FIFO 14 behaves as a scan chain when data has to be scanned through all scan chains of the system during the test. Otherwise the values of *wr_valid_out* and *rd_accept_out* will follow the value of the output of the multiplexer 28 controlled by the test control signal *test_ctrl_sel.* This renders the control signals *test_wr_valid* and *test_rd_accept* as used in the first embodiment unnecessary.

When the pipeline 14 is in a test mode (i.e. *test_ctrl_sel* is logical one) the control signals are directly determined by the output of the scan flip-flop 26. The values in the flip-flops 26 are scanned in during the scan phase of the scan test and are actually applied as though they are part of the stimuli of the test (unlike in the first embodiment in Figs. 5 and 6 where they are static). The control signals can therefore only be controlled during the test:normal mode, but this is sufficient to implement all of the test strategies described below.

Therefore, the additional hardware components required to implement the test architecture according to the present invention are n + 6 multiplexers and four scan flip-flops. If the write and read test blocks are implemented according to the second embodiment of the present invention then two OR gates are also required.

This should be contrasted with the conventional test architecture which requires 2n scan flip-flops and 2n multiplexers. Therefore, the architecture presented herein can provide significant hardware savings over the conventional architecture when the number of bits in a data word is four or higher.

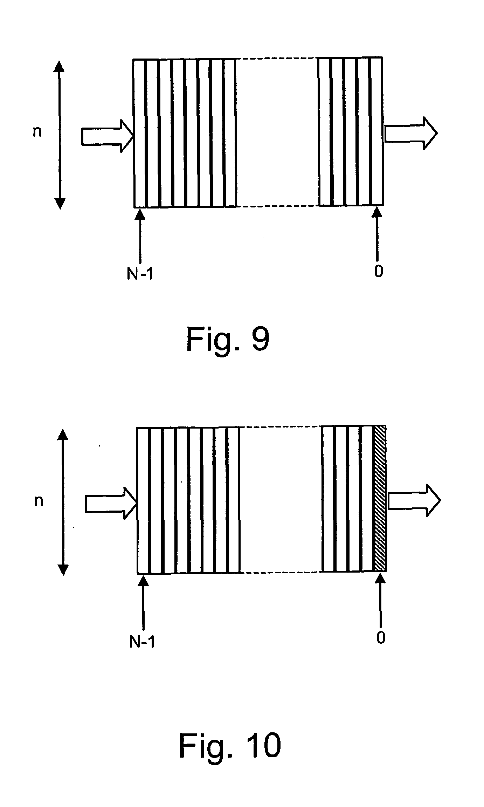

An explanation of the different test strategies that can be used with the test architecture according to the present invention is given below. Fig. 9 shows a schematic view of the memory elements of a mousetrap FIFO. Each vertical bar indicates a storage element for a dataword, and each dataword has a width of n bits. There are N storage elements in total.

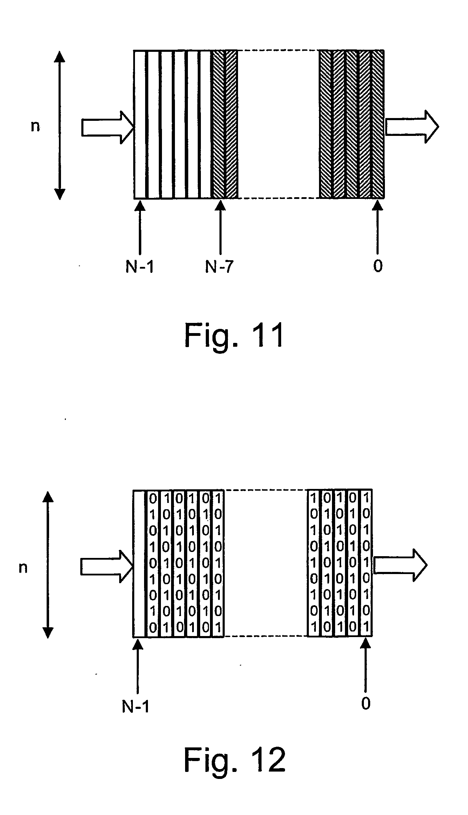

In Fig. 9, all of the storage elements are empty. In Figs. 10 and 11, diagonal lines indicate a full storage element.

The first dataword entering the FIFO will be stored in storage element 0, with the next dataword being stored in element 1, and so on. When reading data from the FIFO, the dataword in element 0 will be read and all of the other datawords will shift one element to the right. This write and read behavior is typical for a mousetrap FIFO. This schematic view is used below to describe the different test strategies that can be applied with the test hardware according to the invention.

The simplest test is the scan test in which a single storage element is used. This element will always be element 0. A schematic view of this test is shown in Fig. 10.

This scan test has several advantages. Firstly, the test does not need initialization, although each FIFO in the system must be reset before testing. Secondly, the control signals for the FIFO are constant. Thirdly, the scan test can be performed at the same time that testing of the logic around the FIFO is carried out. In other words, the test patterns for the complete system (including the FIFOs) can be generated automatically with an Automatic Test Pattern Generator (ATPG) and results in a single scan test. Fourthly, as a result of using the ATPG for the logic and the FIFO at the same time, the interconnections between the two are also tested.

However, this test has the disadvantage that only a limited number of the possible states of the FIFO are tested, and therefore the test does not cover all of the possible faults of the mousetrap FIFO.

To overcome this, scan testing with more than one storage element can be used to test more states of the FIFO. In principal, all different states of the FIFO can be tested. Initially, scan testing with a single storage element is performed as described above, and then scan testing is performed using two storage elements, and then three, and so on. Fig. 11 shows a scan test with *N*-*6* storage elements used.

It is important to note that for the scan test to behave properly, the maximum number of storage elements used in the test is *N-1.*

This scan test strategy has the same advantages as scan testing with a single storage element, except that an initialization phase is required when more than one storage element is used. During this initialization, the FIFO is filled with *N-i* datawords comprising random data bits so that the storage elements can be used in the scan test.

When the FIFO is being filled with the random datawords, the control signals of the FIFO are not constant. However, when the scan test is performed, the control signals are again constant.

Increasing the number of storage elements used in the scan test increases the coverage of the test, but also increases the time required to perform the test.

Another test that is possible using the test architecture according to the present invention is a functional test with memory test patterns.

This test is similar to the test with multiple storage elements, except that only the FIFO will be tested (not the logic around it) and special memory test patterns are required.

One example of a special memory test pattern is shown in Fig. 12. This pattern is known as a checkerboard test pattern as the pattern comprises alternating 0s and 1s.

This test is used to further improve fault coverage, as so-called cross-coupled faults between memory bits can be tested. Again, initialization is required to select the number of storage elements to be used in the test.

After the initialization, the memory test pattern is simply scanned in and scanned out of the FIFO. Again, during the initialization the control signals of the FIFO are variable, whereas during scanning the control signals are constant.

There is therefore provided an architecture for testing embedded mousetrap FIFOs that requires less silicon area than conventional testing architectures. In addition, the architecture also allows the testing of the embedded mousetrap FIFO together with the surrounding logic. With the conventional testing solutions, the mousetrap FIFO is tested separately from the surrounding logic. Finally, normal memory testing of the FIFO is possible.

It should be noted that the above-mentioned embodiments illustrate rather than limit the invention, and that those skilled in the art will be able to design many alternative embodiments without departing from the scope of the appended claims. While the invention is illustrated by means of a pipeline formed by a mousetrap FIFO, the invention is not limited to just that kind of pipelines. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage.

## Claims

1. An architecture for testing an asynchronous pipeline (14) in an integrated circuit, the pipeline (14) having an input port and an output port, and being operable to process a data word having a plurality of data bits, the architecture comprising:
a multiplexer (18) provided at each input of the input port of the pipeline (14), each multiplexer operable to allow a data bit (wr_data) or test data bit (si) to be input to the pipeline;
a write test block (15) for controlling the writing of data bits and test data bits to the pipeline during a normal mode and a test mode of operation respectively; and
a read test block (16) for controlling the reading of data bits and test data bits from the pipeline during the normal mode and the test mode of operation respectively,
**characterized in that** the write test block (15) and the read test block (16) are operable in the test mode to control the pipeline (14) as a scan chain.

2. An architecture as claimed in claim 1, wherein a plurality of multiplexers combine to provide an additional input port (si [CLn-I]) for allowing test data to be introduced to the pipeline.

3. An architecture as claimed in claim 1 or claim 2, wherein a scan chain output port (so[0..n-I]) of the pipeline (14) is connected to a scan chain input port (si[0..n-I]) of the same pipeline (14).

4. An architecture as claimed in claim 1 or claim 2, wherein the scan chain is formed by connecting a scan chain output port (so[0..n-I]) of the pipeline (14) to a scan chain input port signal (si[0..nol]) of a second pipeline (14).

5. An architecture as claimed in claim 1, wherein the write test block (15) is operable to provide a write control signal (wr_valid_out) for writing data to the pipeline (14), the write control signal (wr_valid_out) itself being controlled using test control signals (test_wr_valid, test_ctrl_sel) received by the write test block (15).

6. An architecture as claimed in claim 1, wherein the write test block (15) is operable to provide a write control signal (wr_valid_out) for writing data to the pipeline (14), the write control signal (wr_valid_out) itself being controlled using a test control signal (test_ctrl_sel) received by the write test block (15) and a test control signal previously stored in the write test block (15).

7. An architecture as claimed in claim 1 , wherein the read test block (16) is operable to provide a read control signal (rd_accept_out) for reading data from the pipeline (14), the read control signal (rd_accept_out) itself being controlled using test control signals (test_rd_accept and test_ctrl_sel) received by the read test block (16).

8. An architecture as claimed in claim 1, wherein the read test block (16) is operable to provide a read control signal (rd_accept_out) for reading data from the pipeline (14), the read control signal (rd_accept_out) itself being controlled using a test control signal (test_ctrl_sel) received by the read test block (16) and a control signal previously stored in the read test block (16).

9. An architecture as claimed in claim 1, wherein the write test block (15) and read test block (16) are operable to set a write control signal (wr_valid_out) and a read control signal (read_accept_out) to logic one, respectively, during a scan test mode, thereby enabling test data to be scanned through the pipeline (14).

10. An architecture as claimed in claim 1, wherein the pipeline (14) is an embedded mousetrap FIFO.

11. A method of testing an asynchronous pipeline (14) in an integrated circuit, the pipeline having an input port and an output port, and being operable to process a data word having a plurality of data bits, the method comprising the steps of:
- allowing data bits (wr_data) or test data bits (si) to be input to the pipeline;
- controlling (the writing of data bits and test data bits to the pipeline during a normal mode and a test mode of operation respectively; and
- controlling the reading of data bits and test data bits from the pipeline during the normal mode and the test mode of operation respectively;
the method being **characterized by**:
- controlling the writing and reading of test data bits to control the pipeline (14) as a scan chain in the test mode.

## Patentansprüche

1. Architektur zum Testen einer asynchronen Pipeline (14) in einem integrierten Schaltkreis, wobei die Pipeline (14) einen Eingangsanschluss und einen Ausgangsanschluss aufweist und so betreibbar ist, dass sie ein Datenwort mit einer Vielzahl von Datenbits verarbeitet, wobei die Architektur umfasst:
einen Multiplexer (18), der an jedem Eingang des Eingangsanschlusses der Pipeline (14) vorgesehen ist, wobei jeder Multiplexer so betreibbar ist, dass er erlaubt, ein Datenbit (wr_data) oder ein Testdatenbit (si) in die Pipeline einzugeben;
einen Schreibtestblock (15) zum Steuern des Schreibens von Datenbits und Testdatenbits in die Pipeline während eines Normalbetriebsmodus bzw. eines Testbetriebsmodus; und
einen Lesetestblock (16) zum Steuern des Lesens von Datenbits und Testdatenbits aus der Pipeline während des Normalbetriebsmodus bzw. des Testbetriebsmodus,
**dadurch gekennzeichnet, dass** der Schreibtestblock (15) und der Lesetestblock (16) im Testmodus so betreibbar sind, dass sie die Pipeline (14) als Abtastkette steuern.

2. Architektur nach Anspruch 1, wobei eine Vielzahl von Multiplexern kombiniert ist, um einen zusätzlichen Eingangsanschluss (si[CLn-1]) bereitzustellen, um zu erlauben, Testdaten in die Pipeline einzubringen.

3. Architektur nach Anspruch 1 oder Anspruch 2, wobei ein Abtastkettenausgangsanschluss (so[0..n-1]) der Pipeline (14) mit einem Abtastketteneingangsanschluss (si[0..n-1]) derselben Pipeline (14) verbunden ist.

4. Architektur nach Anspruch 1 oder Anspruch 2, wobei die Abtastkette gebildet wird durch Verbinden eines Abtastkettenausgangsanschlusses (so[0..n-1]) der Pipeline (14) mit einem Abtastketteneingangsanschlusssignal (si[0..no1]) einer zweiten Pipeline (14).

5. Architektur nach Anspruch 1, wobei der Schreibtestblock (15) so betreibbar ist, dass er ein Schreibsteuersignal (wr_valid_out) zum Schreiben von Daten in die Pipeline (14) bereitstellt, wobei das Schreibsteuersignal (wr_valid_out) selbst unter Verwendung von Teststeuersignalen (test_wr_valid, test_ctrl-sel), die vom Schreibtestblock (15) empfangen werden, gesteuert wird.

6. Architektur nach Anspruch 1, wobei der Schreibtestblock (15) so betreibbar ist, dass er ein Schreibsteuersignal (wr_valid_out) zum Schreiben von Daten in die Pipeline (14) bereitstellt, wobei das Schreibsteuersignal (wr_valid_out) selbst unter Verwendung eines Teststeuersignals (test_ctrl_sel), das vom Schreibtestblock (15) empfangen wird, und eines Teststeuersignals, das vorher im Schreibtestblock (15) gespeichert worden ist, gesteuert wird.

7. Architektur nach Anspruch 1, wobei der Lesetestblock (16) so betreibbar ist, dass er ein Lesesteuersignal (rd_accept_out) zum Lesen von Daten aus der Pipeline (14) bereitstellt, wobei das Lesesteuersignal (rd_accept_out) selbst unter Verwendung von Teststeuersignalen (test_rd_accept und test_ctrl_sel), die vom Lesetestblock (16) empfangen werden, gesteuert wird.

8. Architektur nach Anspruch 1, wobei der Lesetestblock (16) so betreibbar ist, dass er ein Lesesteuersignal (rd_accept_out) zum Lesen von Daten aus der Pipeline (14) bereitstellt, wobei das Lesesteuersignal (rd_accept_out) selbst unter Verwendung eines Teststeuersignals (test_ctrl_sel), das vom Lesetestblock (16) empfangen wird, und eines Steuersignals, das vorher im Lesetestblock (16) gespeichert worden ist, gesteuert wird.

9. Architektur nach Anspruch 1, wobei der Schreibtestblock (15) und der Lesetestblock (16) so betreibbar sind, dass sie ein Schreibsteuersignal (wr_valid_out) und ein Lesesteuersignal (read_accept_out) jeweils während eines Abtasttestmodus auf logisch 1 setzen, um somit zu ermöglichen, dass Testdaten durch die Pipeline (14) abgetastet werden.

10. Architektur nach Anspruch 1, wobei die Pipeline (14) eine eingebettete Mausefallen-FIFO-Einrichtung ist.

11. Verfahren zum Testen einer asynchronen Pipeline (14) in einem integrierten Schaltkreis, wobei die Pipeline einen Eingangsanschluss und einen Ausgangsanschluss aufweist und so betreibbar ist, dass sie ein Datenwort mit einer Vielzahl von Datenbits verarbeitet, wobei das Verfahren die Schritte umfasst:
Erlauben der Eingabe von Datenbits (wr_data) oder Testdatenbits (si) in die Pipeline;
Steuern des Schreibens von Datenbits und Testdatenbits in die Pipeline während eines Normalbetriebsmodus bzw. eines Testbetriebsmodus; und
Steuern des Lesens von Datenbits und Testdatenbits aus der Pipeline während des Normalbetriebsmodus bzw. des Testbetriebsmodus;
wobei das Verfahren **gekennzeichnet ist durch**:
Steuern des Schreibens und Lesens von Testdatenbits, um die Pipeline (14) als Abtastkette im Testmodus zu steuern.

## Revendications

1. Architecture permettant de tester un pipeline asynchrone (14) dans un circuit intégré, le pipeline (14) ayant un port d'entrée et un port de sortie, et étant exploitable pour traiter un mot de données ayant une pluralité de binaires de données, l'architecture comprenant :
un multiplexeur (18) prévu au niveau de chaque entrée du port d'entrée du pipeline (14), chaque multiplexeur étant exploitable pour permettre à un binaire de données (wr_data) ou à un binaire de données de test (si) d'être introduit dans le pipeline ;
un bloc de test d'écriture (15) pour commander l'écriture de binaires de données et de binaires de données de test dans le pipeline pendant un mode normal et un mode de test en exploitation, respectivement ; et
un bloc de test de lecture (16) pour commander la lecture de binaires de données et de binaires de données de test provenant du pipeline pendant le mode normal et le mode de test en exploitation, respectivement,
**caractérisée en ce que** le bloc de test d'écriture (15) et le bloc de test de lecture (16) sont exploitables dans le mode de test pour commander le pipeline (14) sous la forme d'une chaîne d'analyse.

2. Architecture selon la revendication 1, dans laquelle une pluralité de multiplexeurs se combine en vue de fournir un port d'entrée supplémentaire (si[CLn-1]) pour permettre à des données de test d'être introduites dans le pipeline.

3. Architecture selon la revendication 1 ou la revendication 2, dans laquelle un port de sortie de chaîne d'analyse (so[0..n-1]) du pipeline (14) est connecté à un port d'entrée de chaîne d'analyse (si[0..n-1]) du même pipeline (14).

4. Architecture selon la revendication 1 ou la revendication 2, dans laquelle la chaîne d'analyse est formée en connectant un port de sortie de chaîne d'analyse (so[0..n-1]) du pipeline (14) à un signal de port d'entrée de chaîne d'analyse (si[0..no1]) d'un second pipeline (14).

5. Architecture selon la revendication 1, dans laquelle le bloc de test d'écriture (15) est exploitable pour fournir un signal de commande d'écriture (wr_valid_out) pour écrire des données dans le pipeline (14), le signal de commande d'écriture (wr_valid_out) étant lui-même commandé en utilisant des signaux de commande de test (test_wr_valid, test_ctrl_sel) reçus par le bloc de test d'écriture (15).

6. Architecture selon la revendication 1, dans laquelle le bloc de test d'écriture (15) est exploitable pour fournir un signal de commande d'écriture (wr_valid_out) pour écrire des données dans le pipeline (14), le signal de commande d'écriture (wr_valid_out) étant lui-même commandé en utilisant un signal de commande de test (test_ctrl_sel) reçu par le bloc de test d'écriture (15) et un signal de commande de test stocké antérieurement dans le bloc de test d'écriture (15).

7. Architecture selon la revendication 1, dans laquelle le bloc de test de lecture (16) est exploitable pour fournir un signal de commande de lecture (rd_accept_out) pour lire des données à partir du pipeline (14), le signal de commande de lecture (rd_accept_out) étant lui-même commandé en utilisant des signaux de commande de test (test_rd_accept et test_ctrl_sel) reçus par le bloc de test de lecture (16).

8. Architecture selon la revendication 1, dans laquelle le bloc de test de lecture (16) est exploitable pour fournir un signal de commande de lecture (rd_accept_out) pour lire des données à partir du pipeline (14), le signal de commande de lecture (rd_accept_out) étant lui-même commandé en utilisant un signal de commande de test (test_ctrl_sel) reçu par le bloc de test de lecture (16) et un signal de commande stocké antérieurement dans le bloc de test de lecture (16).

9. Architecture selon la revendication 1, dans laquelle le bloc de test d'écriture (15) et le bloc de test de lecture (16) sont exploitables pour établir un signal de commande d'écriture (wr_valid_out) et un signal de commande de lecture (read_accept_out) pour une valeur de un logique, respectivement, pendant un mode de test d'analyse, permettant de ce fait à des données de test d'être analysées à travers le pipeline (14).

10. Architecture selon la revendication 1, dans laquelle le pipeline (14) est une FIFO incorporée de branchement non programmé de la souris.

11. Procédé de test d'un pipeline asynchrone (14) dans un circuit intégré, le pipeline ayant un port d'entrée et un port de sortie, et étant exploitable pour traiter un mot de données comportant une pluralité de binaires de données, le procédé comprenant les étapes consistant à :
- permettre à des binaires de données (wr_data) ou à des binaires de données de test d'être introduits dans le pipeline ;
- commander (l'écriture des binaires de données et des binaires de données de test dans le pipeline pendant un mode normal et le mode de test en exploitation respectivement ; et
- commander la lecture des binaires de données et des binaires de données de test provenant du pipeline pendant le mode normal et le mode de test en exploitation, respectivement ;
le procédé étant **caractérisé par** le fait de
- commander l'écriture et la lecture des binaires de données de test pour commander le pipeline (14) sous la forme d'une chaîne d'analyse dans le mode de test.
